# EUROPEAN PATENT APPLICATION

(11) **EP 4 525 022 A1**
(43) Date of publication of application: **19.03.2025**
(21) Application number: 22946116.5
(22) Date of filing: 13.06.2022

(54) **MEMORY ARRAY AND MANUFACTURING METHOD THEREFOR, MEMORY, AND ELECTRONIC DEVICE**

(71) Applicant: Huawei Technologies Co., Ltd., Shenzhen, Guangdong 518129 (CN)
(72) Inventor: TAN, Wanliang, Shenzhen, Guangdong 518129 (CN); XU, Jeffrey Junhao, Shenzhen, Guangdong 518129 (CN)
(74) Representative: Gill Jennings & Every LLP
(86) International application number: PCT/CN2022/098471
(87) International publication number: WO 2023/240416

(57) **Abstract**

Embodiments of this application relate to the field of semiconductor storage technologies, and provide a memory array and a preparation method thereof, a memory, and an electronic device, to improve an anti-disturbance capability of a memory cell in a memory read/write process. The memory array includes a substrate and a plurality of memory cells formed on the substrate, where each memory cell includes a ferroelectric capacitor. The ferroelectric capacitor includes a first electrode and a second electrode, and a hafnium oxide-based ferroelectric layer serving as a storage medium and a non-linear resistor layer used for changing a voltage of the ferroelectric layer, which are connected in series between the first electrode and the second electrode. A material of the nonlinear resistor layer has a characteristic that a resistance nonlinearly decreases as an applied voltage increases. In this case, the ferroelectric layer correspondingly has a characteristic that a divided voltage obtained by the ferroelectric layer nonlinearly increases as a voltage applied to the ferroelectric capacitor increases, to improve an anti-disturbance capability of the memory cell to a small voltage.

## Description

### TECHNICAL FIELD

This application relates to the field of semiconductor storage technologies, and in particular, to a memory array and a preparation method thereof, a memory, and an electronic device.

### BACKGROUND

A memory is an apparatus for information storage. Generally, information is digitized and then stored in a medium that uses an electrical, magnetic, or optical manner. A ferroelectric random access memory (ferroelectric random access memory, FRAM) is a new type of memory. Compared with a conventional memory like a dynamic random access memory (dynamic random access memory, DRAM) or a flash memory, the ferroelectric random access memory is widely used because of advantages like a low read/write voltage, low power consumption, a small device size, a high read/write speed, good cycle performance, radiation resistance, and non-volatility.

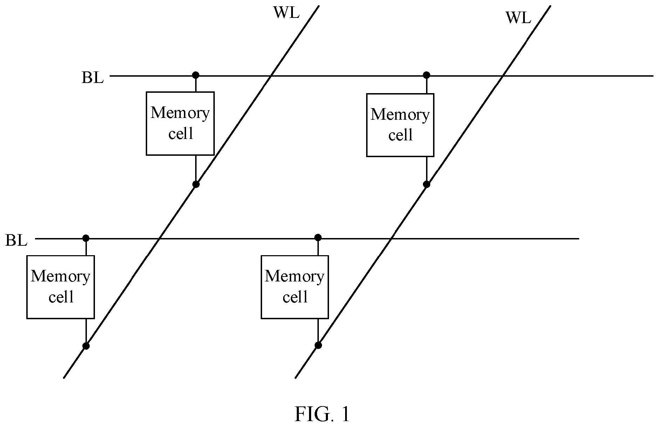

To increase a storage capacity of the FRAM, an existing FRAM may adopt a crossbar (crossbar) array structure. As shown in FIG. 1, the crossbar array structure has a plurality of word lines (word line, WL) and a plurality of bit lines (bit line, BL). The word lines WL and the bit lines BL are connected to form an array. A memory cell is disposed at a location at which one word line WL and one bit line BL are crossed, and a read or write operation may be performed on the memory cell through voltage regulation between the WL and the BL.

However, because each word line WL and each bit line BL in the crossbar array structure are separately connected to a plurality of memory cells, a read/write process performed on a specific memory cell may cause disturbance to another memory cell. Consequently, information of the another memory cell is difficult to be read or even lost.

### SUMMARY

Embodiments of this application provide a memory array and a preparation method thereof, a memory, and an electronic device, to improve an anti-disturbance capability of a memory cell in a memory read/write process.

To achieve the foregoing objective, the following technical solutions are used in this application.

According to a first aspect of embodiments of this application, a memory array is provided. The memory array may be used in a memory, and the memory may be, for example, a ferroelectric random access memory (ferroelectric random access memory, FRAM). The memory array includes a substrate and a plurality of memory cells formed on the substrate, where each memory cell includes a ferroelectric capacitor. The ferroelectric capacitor includes a first electrode, a second electrode, and a ferroelectric layer disposed between the first electrode and the second electrode, where the ferroelectric layer is used as a storage medium, and a material of the ferroelectric layer may include a hafnium oxide-based material. In addition, the ferroelectric capacitor further includes at least one nonlinear resistor layer that is disposed between the first electrode and the second electrode and that is parallel to the ferroelectric layer. In other words, the ferroelectric capacitor includes the nonlinear resistor layer that is connected in series to the ferroelectric layer to divide a voltage. A resistance of a material of the nonlinear resistor layer nonlinearly decreases as an applied voltage increases. In this case, the resistance of the nonlinear resistor layer nonlinearly decreases as a voltage applied to the ferroelectric capacitor increases, and a divided voltage obtained by the corresponding ferroelectric layer nonlinearly increases. In other words, the divided voltage of the ferroelectric layer first slowly increases, and then rapidly increases as the voltage applied to the ferroelectric capacitor increases.

According to the memory array provided in embodiments of this application, the nonlinear resistor layer parallel to the ferroelectric layer is inserted into the ferroelectric capacitor, so that the nonlinear resistor layer and the ferroelectric layer perform voltage division on the voltage applied to the ferroelectric capacitor. The material of the nonlinear resistor layer has a characteristic that the resistance nonlinearly decreases as an applied voltage increases, so that the resistance of the nonlinear resistor layer nonlinearly decreases as the applied voltage increases. Therefore, after the nonlinear resistor layer is placed in the ferroelectric capacitor, the resistance of the nonlinear resistor layer nonlinearly decreases as the voltage applied to the ferroelectric capacitor increases, and the divided voltage obtained by the nonlinear resistor layer nonlinearly decreases. Correspondingly, the divided voltage obtained by the ferroelectric layer nonlinearly increases as the voltage applied to the ferroelectric capacitor increases. In other words, when the voltage applied to the ferroelectric capacitor is small, a proportion of the divided voltage obtained by the ferroelectric layer is small. When the voltage applied to the ferroelectric capacitor is large, the proportion of the divided voltage obtained by the ferroelectric layer is large. In this case, ferroelectric polarization reversal of the ferroelectric capacitor also has the characteristic of a nonlinear change with a voltage change. In other words, when the voltage applied to the ferroelectric capacitor is small (a disturbance voltage), the proportion of the divided voltage obtained by the ferroelectric layer is small, and a ferroelectric polarization reversal amount of the ferroelectric capacitor is small, which has little impact on a storage status of the memory cell. When the voltage applied to the ferroelectric capacitor is large (a read/write voltage), the proportion of the divided voltage obtained by the ferroelectric layer is large, and the ferroelectric polarization reversal amount of the ferroelectric capacitor is large, so that a read/write operation can be normally completed. In this way, existence of the nonlinear resistor layer may regulate a voltage response characteristic of the memory cell, and enhance a nonlinear response characteristic that is of the memory cell and that is obtained when the voltage increases, to suppress ferroelectric polarization reversal that is at a low voltage and that is of the ferroelectric capacitor, and effectively enhance anti-disturbance performance of the memory cell.

In a possible implementation, the material of the nonlinear resistor layer is a conductive material having a resistive switching characteristic. In other words, the material of the nonlinear resistor layer is a conductive material, and a resistance of the material of the nonlinear resistor layer may change as the voltage changes. This is a low-cost implementation.

In a possible implementation, the material of the nonlinear resistor layer has a metal-insulator transition characteristic. In other words, the material of the nonlinear resistor layer can change from a metal material to an insulation material as the voltage changes. This is a low-cost implementation.

In a possible implementation, the material of the nonlinear resistor layer includes a transition metal oxide, a lanthanum oxide, a perovskite composite oxide, a solid electrolyte, or an organic polymer. This is a possible implementation.

In a possible implementation, the material of the nonlinear resistor layer includes at least one of Ta₂O₅, Nb₂O₅, TiO₂, HfO₂, GeSbTe, or AgInSbTe. This is a possible implementation.

In a possible implementation, the nonlinear resistor layer is disposed on at least one side of the ferroelectric layer. This is a possible implementation.

In a possible implementation, the ferroelectric capacitor further includes at least one third electrode, the third electrode is disposed between the first electrode and the second electrode, and the third electrode is disposed between the ferroelectric layer and the nonlinear resistor layer. The ferroelectric layer and the nonlinear resistor layer are disposed at an interval, so that effect of the nonlinear resistor layer on the ferroelectric polarization of the ferroelectric layer can be reduced.

In a possible implementation, the first electrode and the second electrode are disposed in a direction perpendicular to the substrate. This is a possible implementation.

In a possible implementation, the first electrode and the second electrode are disposed in a direction parallel to the substrate. This is a possible implementation.

In a possible implementation, the material of the ferroelectric layer includes a hafnium oxide-based material. A thickness size of the hafnium oxide-based ferroelectric capacitor may be miniaturized to 10 nanometers or even sub-ten nanometers. In this way, high-density integration and even three-dimensional integration can be implemented, and a large advantage of the hafnium oxide-based ferroelectric capacitor exists in constructing an ultra-high-density memory chip. In addition, a preparation process of the hafnium oxide-based ferroelectric capacitor may be well compatible with a silicon-based semiconductor process. In this way, the ferroelectric capacitor may be prepared by using a mature manufacturing process, and manufacturing costs are not increased.

According to a second aspect of embodiments of this application, a memory array is provided. The memory array includes a substrate and a plurality of memory cells formed on the substrate, where each memory cell includes a ferroelectric capacitor. The ferroelectric capacitor includes a first electrode, a second electrode, and a ferroelectric layer disposed between the first electrode and the second electrode, where the ferroelectric layer is used as a storage medium, and a material of the ferroelectric layer may include a hafnium oxide-based material. In addition, the ferroelectric capacitor further includes at least one nonlinear resistor layer that is disposed between the first electrode and the second electrode and that is parallel to the ferroelectric layer. In other words, the ferroelectric capacitor includes the nonlinear resistor layer that is connected in series to the ferroelectric layer to divide a voltage. The plurality of memory cells are disposed on the substrate, where each of the memory cells includes the ferroelectric capacitor. A material of the nonlinear resistor layer is a conductive material having a resistive switching characteristic.

According to the memory array provided in embodiments of this application, the nonlinear resistor layer parallel to the ferroelectric layer is inserted into the ferroelectric capacitor, so that the nonlinear resistor layer and the ferroelectric layer perform voltage division on a voltage applied to the ferroelectric capacitor. The material of the nonlinear resistor layer is the conductive material having the resistive switching characteristic, so that a resistance of the nonlinear resistor layer nonlinearly decreases as the applied voltage increases. Therefore, after the nonlinear resistor layer is placed in the ferroelectric capacitor, the resistance of the nonlinear resistor layer nonlinearly decreases as the voltage applied to the ferroelectric capacitor increases, and a divided voltage obtained by the nonlinear resistor layer nonlinearly decreases. Correspondingly, the divided voltage obtained by the ferroelectric layer nonlinearly increases as the voltage applied to the ferroelectric capacitor increases. In other words, when the voltage applied to the ferroelectric capacitor is small, a proportion of the divided voltage obtained by the ferroelectric layer is small. When the voltage applied to the ferroelectric capacitor is large, the proportion of the divided voltage obtained by the ferroelectric layer is large. In this case, ferroelectric polarization reversal of the ferroelectric capacitor also has the characteristic of a nonlinear change with a voltage change. In other words, when the voltage applied to the ferroelectric capacitor is small (a disturbance voltage), the proportion of the divided voltage obtained by the ferroelectric layer is small, and a ferroelectric polarization reversal amount of the ferroelectric capacitor is small, which has little impact on a storage status of the memory cell. When the voltage applied to the ferroelectric capacitor is large (a read/write voltage), the proportion of the divided voltage obtained by the ferroelectric layer is large, and the ferroelectric polarization reversal amount of the ferroelectric capacitor is large, so that a read/write operation can be normally completed. In this way, existence of the nonlinear resistor layer may regulate a voltage response characteristic of the memory cell, and enhance a nonlinear response characteristic that is of the memory cell and that is obtained when the voltage increases, to suppress ferroelectric polarization reversal that is at a low voltage and that is of the ferroelectric capacitor, and effectively enhance anti-disturbance performance of the memory cell.

In a possible implementation, the material of the nonlinear resistor layer includes a transition metal oxide, a lanthanum oxide, a perovskite composite oxide, or an organic polymer. This is a low-cost implementation.

In a possible implementation, the material of the nonlinear resistor layer includes at least one of Ta₂O₅, Nb₂O₅, TiO₂, or HfO₂. This is a low-cost implementation.

In a possible implementation, the ferroelectric capacitor further includes at least one third electrode, the third electrode is disposed between the first electrode and the second electrode, and the third electrode is disposed between the ferroelectric layer and the nonlinear resistor layer. The ferroelectric layer and the nonlinear resistor layer are disposed at an interval, so that effect of the nonlinear resistor layer on the ferroelectric polarization of the ferroelectric layer can be reduced.

In a possible implementation, the first electrode and the second electrode are disposed in a direction perpendicular to the substrate. This is a possible implementation.

In a possible implementation, the first electrode and the second electrode are disposed in a direction parallel to the substrate. This is a possible implementation.

In a possible implementation, the material of the ferroelectric layer includes a hafnium oxide-based material. A thickness size of the hafnium oxide-based ferroelectric capacitor may be miniaturized to 10 nanometers or even sub-ten nanometers. In this way, high-density integration and even three-dimensional integration can be implemented, and a large advantage of the hafnium oxide-based ferroelectric capacitor exists in constructing an ultra-high-density memory chip. In addition, a preparation process of the hafnium oxide-based ferroelectric capacitor may be well compatible with a silicon-based semiconductor process. In this way, the ferroelectric capacitor may be prepared by using a mature manufacturing process, and manufacturing costs are not increased.

According to a third aspect of embodiments of this application, a memory array is provided. The memory array includes a substrate and a plurality of memory cells formed on the substrate, where each memory cell includes a ferroelectric capacitor. The ferroelectric capacitor includes a disposed first electrode, a disposed second electrode, and a ferroelectric layer disposed between the first electrode and the second electrode, where the ferroelectric layer is used as a storage medium, and a material of the ferroelectric layer may include a hafnium oxide-based material. In addition, the ferroelectric capacitor further includes at least one nonlinear resistor layer that is disposed between the first electrode and the second electrode and that is parallel to the ferroelectric layer. In other words, the ferroelectric capacitor includes the nonlinear resistor layer that is connected in series to the ferroelectric layer to divide a voltage. The plurality of memory cells are disposed on the substrate, where each of the memory cells includes the ferroelectric capacitor. The material of the nonlinear resistor layer has a metal-insulator transition characteristic.

According to the memory array provided in embodiments of this application, the nonlinear resistor layer parallel to the ferroelectric layer is inserted into the ferroelectric capacitor, so that the nonlinear resistor layer and the ferroelectric layer perform voltage division on a voltage applied to the ferroelectric capacitor. The material of the nonlinear resistor layer has the metal-insulator transition characteristic, so that a resistance of the nonlinear resistor layer nonlinearly decreases as the applied voltage increases. Therefore, after the nonlinear resistor layer is placed in the ferroelectric capacitor, the resistance of the nonlinear resistor layer nonlinearly decreases as the voltage applied to the ferroelectric capacitor increases, and a divided voltage obtained by the nonlinear resistor layer nonlinearly decreases. Correspondingly, the divided voltage obtained by the ferroelectric layer nonlinearly increases as the voltage applied to the ferroelectric capacitor increases. In other words, when the voltage applied to the ferroelectric capacitor is small, a proportion of the divided voltage obtained by the ferroelectric layer is small. When the voltage applied to the ferroelectric capacitor is large, the proportion of the divided voltage obtained by the ferroelectric layer is large. In this case, ferroelectric polarization reversal of the ferroelectric capacitor also has the characteristic of a nonlinear change with a voltage change. In other words, when the voltage applied to the ferroelectric capacitor is small (a disturbance voltage), the proportion of the divided voltage obtained by the ferroelectric layer is small, and a ferroelectric polarization reversal amount of the ferroelectric capacitor is small, which has little impact on a storage status of the memory cell. When the voltage applied to the ferroelectric capacitor is large (a read/write voltage), the proportion of the divided voltage obtained by the ferroelectric layer is large, and the ferroelectric polarization reversal amount of the ferroelectric capacitor is large, so that a read/write operation can be normally completed. In this way, existence of the nonlinear resistor layer may regulate a voltage response characteristic of the memory cell, and enhance a nonlinear response characteristic that is of the memory cell and that is obtained when the voltage increases, to suppress ferroelectric polarization reversal that is at a low voltage and that is of the ferroelectric capacitor, and effectively enhance anti-disturbance performance of the memory cell.

In a possible implementation, the material of the nonlinear resistor layer includes a solid electrolyte. This is a low-cost implementation.

In a possible implementation, the material of the nonlinear resistor layer includes at least one of GeSbTe or AgInSbTe. This is a low-cost implementation.

In a possible implementation, the ferroelectric capacitor further includes at least one third electrode, the third electrode is disposed between the first electrode and the second electrode, and the third electrode is disposed between the ferroelectric layer and the nonlinear resistor layer. The ferroelectric layer and the nonlinear resistor layer are disposed at an interval, so that effect of the nonlinear resistor layer on the ferroelectric polarization of the ferroelectric layer can be reduced.

In a possible implementation, the first electrode and the second electrode are disposed in a direction perpendicular to the substrate. This is a possible implementation.

In a possible implementation, the first electrode and the second electrode are disposed in a direction parallel to the substrate. This is a possible implementation.

In a possible implementation, the material of the ferroelectric layer includes a hafnium oxide-based material. A thickness size of the hafnium oxide-based ferroelectric capacitor may be miniaturized to 10 nanometers or even sub-ten nanometers. In this way, high-density integration and even three-dimensional integration can be implemented, and a large advantage of the hafnium oxide-based ferroelectric capacitor exists in constructing an ultra-high-density memory chip. In addition, a preparation process of the hafnium oxide-based ferroelectric capacitor may be well compatible with a silicon-based semiconductor process. In this way, the ferroelectric capacitor may be prepared by using a mature manufacturing process, and manufacturing costs are not increased.

According to a fourth aspect of embodiments of this application, a memory is provided, including a controller, and the memory array according to any one of the first aspect, the second aspect, and the third aspect, where the controller is electrically connected to the memory array. The memory provided in this embodiment of this application includes the memory array in the first aspect, the second aspect, or the third aspect. Beneficial effect of the memory array is the same as beneficial effect of the memory array. Details are not described herein.

According to a fifth aspect of embodiments of this application, an electronic device is provided, including a circuit board and the memory according to the fourth aspect, where the circuit board is electrically connected to the memory.

According to a sixth aspect of embodiments of this application, a memory array preparation method is provided, including: forming a plurality of memory cells on a substrate, where each memory cell includes a ferroelectric capacitor. The ferroelectric capacitor includes a first electrode and a second electrode, and a ferroelectric layer and at least one nonlinear resistor layer that are disposed between the first electrode and the second electrode, and a resistance of a material of the nonlinear resistor layer nonlinearly decreases as an applied voltage increases.

The memory array preparation method provided in this embodiment of this application is used to prepare the memory array in the first aspect. Beneficial effect of the memory array preparation method is the same as beneficial effect of the memory array. Details are not described herein.

In a possible implementation, the material of the nonlinear resistor layer is a conductive material having a resistive switching characteristic.

In a possible implementation, the material of the nonlinear resistor layer has a metal-insulator transition characteristic.

In a possible implementation, the material of the nonlinear resistor layer includes a transition metal oxide, a lanthanum oxide, a perovskite composite oxide, a solid electrolyte, or an organic polymer.

In a possible implementation, the material of the nonlinear resistor layer includes at least one of Ta₂O₅, Nb₂O₅, TiO₂, HfO₂, GeSbTe, or AgInSbTe.

In a possible implementation, the ferroelectric capacitor further includes at least one third electrode, the third electrode is disposed between the first electrode and the second electrode, and the third electrode is disposed between the ferroelectric layer and the nonlinear resistor layer.

According to a seventh aspect of embodiments of this application, a memory array preparation method is provided, and is used to prepare the memory array in the second aspect or the third aspect.

### BRIEF DESCRIPTION OF DRAWINGS

FIG. 1 shows an arrangement manner of a crossbar array structure of a memory according to a related technology;
FIG. 2 is a circuit diagram of an electronic device according to an embodiment of this application;
FIG. 3 is a circuit diagram of a memory according to an embodiment of this application;
FIG. 4 is a circuit diagram of a memory cell of a memory array according to an embodiment of this application;
FIG. 5 is a circuit diagram of a memory array according to an embodiment of this application;
FIG. 6 is a circuit diagram of a memory cell of another memory array according to an embodiment of this application;
FIG. 7 is a circuit diagram of another memory array according to an embodiment of this application;
FIG. 8A is a diagram of a location relationship between a ferroelectric capacitor and a substrate according to an embodiment of this application;
FIG. 8B is a diagram of a location relationship between another ferroelectric capacitor and a substrate according to an embodiment of this application;
FIG. 8C is a schematic top view of a ferroelectric capacitor according to an embodiment of this application;
FIG. 9A to FIG. 9E are diagrams of structures of a ferroelectric capacitor according to an embodiment of this application;
FIG. 10A is a schematic electrical characteristic curve of a memory cell according to an embodiment of this application;
FIG. 10B is an electrical characteristic curve that is of a memory cell and that is obtained when a positive electric field is applied according to an embodiment of this application;
FIG. 11A is a curve of a voltage changing with time according to an embodiment of this application;
FIG. 11B is a curve of a divided voltage obtained by a ferroelectric layer as a voltage changes according to an embodiment of this application;
FIG. 11C is a remnant polarization strength curve of a memory cell as a voltage changes according to an embodiment of this application;
FIG. 11D is a curve of a polarization charge, of a memory cell, changing with a voltage according to an embodiment of this application;
FIG. 12A is another curve of a divided voltage obtained by a ferroelectric layer as a voltage changes according to an embodiment of this application;
FIG. 12B is another remnant polarization strength curve of a memory cell as a voltage changes according to an embodiment of this application;
FIG. 12C is another curve of a polarization charge, of a memory cell, changing with a voltage according to an embodiment of this application; and
FIG. 13A to FIG. 14D are diagrams of structures of another ferroelectric capacitor according to an embodiment of this application.

### Reference numerals:

200: electronic device; 210: system-on-a-chip; 211: application processor; 212: image processing unit; 213: random access memory; 220: read-only memory; 230: communication chip; 240: power management chip; 250: bus; 300: memory; 310: memory array; 320: decoder; 330: driver; 340: timing controller; 350: buffer; 360: input/output driver; 400: memory cell; 401: memory cell; 402: memory cell; 403: memory cell; 404: memory cell; 11: first electrode; 12: second electrode; 13: ferroelectric layer; 14: nonlinear resistor layer; 15: third electrode; and 100: substrate.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

Terms such as "first" and "second" below are merely for ease of description, and shall not be understood as an indication or implication of relative importance or implicit indication of a quantity of indicated technical features. Therefore, a feature limited by "first", "second", or the like may explicitly or implicitly include one or more features. In the descriptions of this application, unless otherwise stated, "a plurality of" means two or more than two.

In addition, in embodiments of this application, orientation terms such as "up", "down", "left", and "right" may include but are not limited to orientations of schematically placed components in relative accompanying drawings. It should be understood that these orientation terms may be relative concepts. The orientation terms are used for relative description and clarification, and may vary correspondingly based on a change in an orientation in which the component is placed in the accompanying drawings.

In embodiments of this application, unless otherwise clearly specified and limited, a term "connection" should be understood in a broad sense. For example, the "connection" may be a fixed connection, a detachable connection, or an integrated connection, or may be a direct connection or an indirect connection implemented through an intermediate medium. In addition, the term "coupling" may be a direct electrical connection, or may be an indirect electrical connection through an intermediate medium. A term "contact" may be direct contact or indirect contact through an intermediate medium.

In embodiments of this application, the term "and/or" describes an association relationship between associated objects and may indicate that three relationships exist. For example, A and/or B may indicate the following cases: Only A exists, both A and B exist, and only B exists, where A and B may be singular or plural. A character "/" usually indicates an "or" relationship between the associated objects.

Before embodiments in this application are described, technical terms in this application are first described. Details are as follows.

A ferroelectric material maintains spontaneous polarization by applying an electric field to arrange an internal electric dipole moment, even when an external applied electric field is removed. In other words, the ferroelectric is a material in which a polarization strength (polarization) value (or an electric field) is retained semipermanently, even after a constant voltage is applied and the voltage is restored to zero volt.

A unit cell is a structure in which a large quantity of micro-object units (such as atoms, ions, and molecules) are arranged according to specific rules.

In a ferroelectric crystal, a structure of a unit cell makes centers of positive and negative charges not coincide and an electric dipole moment appears, and an electric polarization strength that is not equal to zero is generated, so that the crystal has spontaneous polarization. In addition, a direction of the electric dipole moment can change with an external electric field, presenting a characteristic similar to that of a ferromagnet.

Memories are classified into a volatile (volatile) memory (also referred to as an internal memory) and a non-volatile (non-volatile) memory (also referred to as an external memory). The volatile memory is a memory in which stored information disappears after a current is interrupted, for example, a common dynamic random access memory (Dynamic Random Access Memory, DRAM) or a static random access memory (Static Random Access Memory, SRAM). A difference between the DRAM and the SRAM lies in that the DRAM needs to be charged periodically, while the SRAM only needs to be kept powered on and does not need to be updated periodically. The non-volatile memory is a memory in which stored information does not disappear after a current is interrupted, for example, various types of read-only memories (Read-Only Memory, ROM), and a new type of memory like a magnetic random access memory (Magnetic Random Access Memory, MRAM) or a ferroelectric random access memory (Ferroelectric Random Access Memory, FRAM).

The ferroelectric random access memory (ferroelectric random access memory, FRAM) stores data based on ferroelectric effect of a ferroelectric material. A ferroelectric memory is expected to be a main competitor for replacing the dynamic random access memory (dynamic random access memory, DRAM) because of advantages of high storage density, low power consumption, a small size, a low read/write voltage, a high read/write speed, good cycle performance, radiation resistance, and non-volatility. A memory cell in the ferroelectric memory includes a transistor and a ferroelectric capacitor, and the ferroelectric capacitor stores information based on ferroelectric effect. The ferroelectric capacitor includes two electrodes and a ferroelectric material, like a ferroelectric layer, disposed between the two electrodes. Due to a nonlinear characteristic of the ferroelectric material, a dielectric constant of the ferroelectric material can be adjusted, and a difference of dielectric constants obtained before and after a polarization state of the ferroelectric layer is reversed is excessively large. Therefore, the ferroelectric capacitor has a smaller size than another capacitor, for example, a capacitor for storing charges in the DRAM.

In the ferroelectric memory, the ferroelectric layer can be formed by using a common ferroelectric material. After crystallization, a ferroelectric crystal structure can be formed in the ferroelectric layer. When an electric field is applied to the ferroelectric layer of the memory cell, a central atom stops in a low-energy state in the electric field. On the contrary, when electric field reversal is applied to the ferroelectric layer, the central atom moves in a crystal in a direction of the electric field and stops in another low-energy state. A large quantity of central atoms move and are coupled in a unit cell of the crystal to form a ferroelectric domain (ferroelectric domain), and the ferroelectric domain forms a polarization charge under an action of the electric field. The ferroelectric domain forms a high polarization charge under electric field reversal, and forms a low polarization charge without electric field reversal. A binary stable state of the ferroelectric material allows ferroelectricity to be used for a memory.

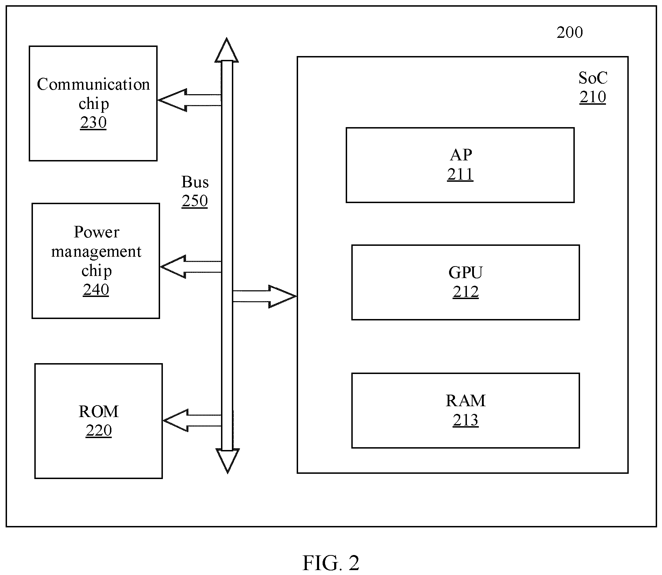

An embodiment of this application provides an electronic device including a memory. The memory may be, for example, a ferroelectric memory. FIG. 2 shows an electronic device 200 according to an embodiment of this application. The electronic device 200 may be a terminal device, for example, a mobile phone, a tablet computer, or a smart band, or may be a personal computer (personal computer, PC), a server, a workstation, or the like. The electronic device 200 includes a bus 250, and a system-on-a-chip (system-on-a-chip, SoC) 210 and a read-only memory (read-only memory, ROM) 220 that are connected to the bus 250. The SoC 210 may be configured to process data, for example, process data of an application, process image data, and cache temporary data. The ROM 220 may be configured to store non-volatile data, for example, an audio file or a video file. The ROM 220 may be a PROM (programmable read-only memory, programmable read-only memory), an EPROM (erasable programmable read-only memory, erasable programmable read-only memory), a flash memory (flash memory), or the like.

In addition, the electronic device 200 may further include a communication chip 230 and a power management chip 240. The communication chip 230 may be configured to process a protocol stack, or perform processing such as amplification and filtering on an analog radio frequency signal, or implement the foregoing functions at same time. The power management chip 240 may be configured to supply power to another chip.

In an implementation, the SoC 210 may include an application processor (application processor, AP) 211 configured to process an application, a graphics processing unit (graphics processing unit, GPU) 212 configured to process image data, and a random access memory (random access memory, RAM) 213 configured to cache data.

The AP 211, the GPU 212, and the RAM 213 may be integrated into one die (die), or may be separately integrated into a plurality of dies (dies), and are packaged in a packaging structure. For example, 2.5D (dimension), 3D packaging, or another advanced packaging technology is used.

In an implementation, the foregoing AP 211 and the foregoing GPU 212 are integrated into one die, the RAM 213 is integrated into another die, and the two dies are packaged in a packaging structure, to obtain a faster inter-die data transmission rate and a higher data transmission bandwidth.

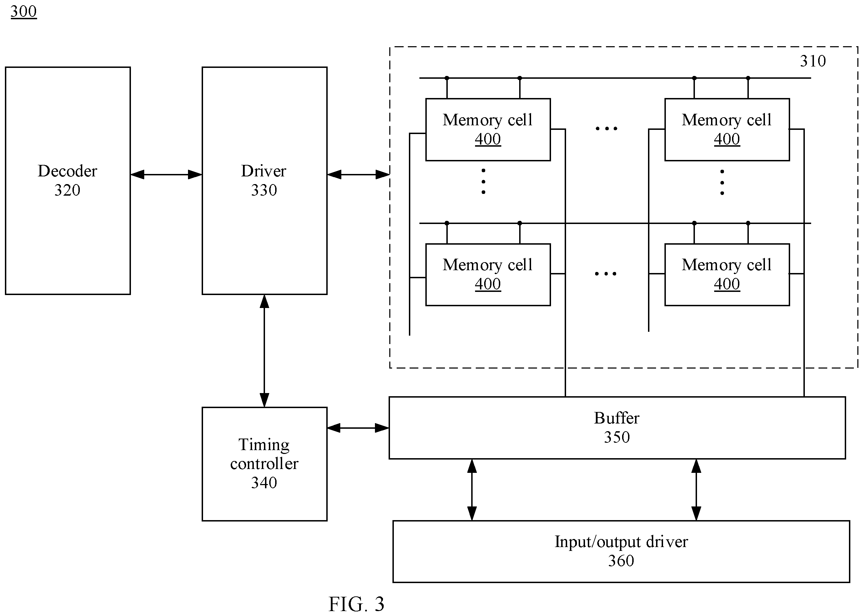

FIG. 3 is a diagram of a structure of a memory 300 according to an embodiment of this application. The memory 300 may be a ferroelectric memory. The ferroelectric memory 300 may be the RAM 213 shown in FIG. 2, and belongs to a FRAM. In an implementation, the memory 300 may alternatively be a RAM disposed outside the SoC 210. A location of the memory 300 in a device and a location relationship between the memory 300 and the SoC 210 are not limited in this application.

Certainly, the memory 300 provided in this embodiment of this application may not be assembled in an electronic device, and the memory 300 directly exists as a single product. For example, the memory is a solid state disk (solid state disk, SSD) or a magnetoresistive random access memory (magnetoresistive random access memory, MRAM).

Still as shown in FIG. 3, the memory 300 includes a memory array 310 and a controller. The controller is electrically connected to the memory array, and is configured to control reading/writing of a memory cell in the memory array. The controller may include logic for controlling read/write timing, and the controller may also include an analog circuit part (for example, a sense amplifier). For example, the controller may include, for example, at least one of a decoder 320, a driver 330, a timing controller 340, a buffer 350, and an input/output driver 360.

It should be noted that the memory array 310 may be independently integrated into a chip (or a bare chip), and the controller is independently integrated into a chip. The memory array chip and the controller chip are integrated and interconnected to form the foregoing memory. The memory array 310 and the controller may alternatively be integrated into a same chip.

Still refer to FIG. 3, the memory array 310 includes a plurality of memory cells 400 arranged in an array. Each memory cell 400 may be configured to store one-bit or multi-bit data. The memory array 310 further includes signal lines such as a word line (word line, WL) and a bit line (bit line, BL). Each memory cell 400 is electrically connected to a corresponding word line WL and a corresponding bit line BL. One or more of the foregoing word line WL, or the foregoing bit line BL are configured to select, by receiving a control level output by a control circuit, a tobe-read/written memory cell 400 in the memory array, to change a polarization direction of a ferroelectric capacitor in the memory cell 400, to implement a data read/write operation.

In a structure of the memory 300 shown in FIG. 3, the decoder 320 is configured to perform decoding based on a received address, to determine a memory cell 400 to be accessed. The driver 330 is configured to control a level of a signal line based on a decoding result generated by the decoder 320, to implement access to a specified memory cell 400. The buffer 350 is configured to buffer read data, for example, may buffer the data in a first-in first-out (first-in first-out, FIFO) manner. The timing controller 340 is configured to control timing of the buffer 350, and control the driver 330 to drive a signal line in the memory array 310. The input/output driver 360 is configured to drive a transmission signal, for example, drive a received data signal and drive a data signal to be sent, so that the data signals can be transmitted over long distances.

The foregoing memory array 310, decoder 320, driver 330, timing controller 340, buffer 350, and input/output driver 360 may be integrated into one chip, or may be integrated into a plurality of chips.

The memory 300 in this application may be a ferroelectric random access memory (ferroelectric random access memory, FRAM), or may be a ferroelectric field effect transistor (ferroelectric field effect transistor, FeFET) memory.

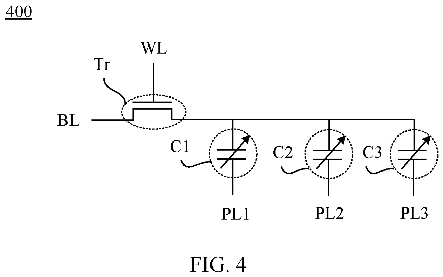

For example, FIG. 4 shows a diagram of a circuit structure of a memory cell 400 of the FRAM. As shown in FIG. 4, the memory cell 400 includes at least one ferroelectric capacitor (a ferroelectric capacitor C1, a ferroelectric capacitor C2, and a ferroelectric capacitor C3 shown in FIG. 4) and a transistor Tr. Such a memory cell 400 may be referred to as a 1TnC memory cell. When the memory cell 400 includes a ferroelectric capacitor and a transistor Tr, the memory cell 400 may be referred to as a 1T1C memory cell.

The transistor Tr herein may be a metal-oxide-semiconductor field-effect transistor (metal-oxide-semiconductor field-effect transistor, MOSFET).

In addition, the memory cell 400 further includes a word line (word line, WL), a bit line (bit line, BL), and a plate line (plate line, PL). In the memory cell 400, a first end of the transistor Tr is electrically connected to the bit line BL, a control end of the transistor Tr is electrically connected to the word line WL, a second end of the transistor Tr is electrically connected to one end of a capacitor C, and the other end of the capacitor C is electrically connected to the board line PL.

In this application, one of a drain (drain) or a source (source) of the transistor Tr is referred to as the first end, the other is correspondingly referred to as the second end, and the control end of the transistor Tr is a gate. The drain and the source of the transistor Tr may be determined based on a flow direction of a current. For example, in FIG. 4, when the current flows from left to right, the left end is the drain, and the right end is the source. On the contrary, when the current flows from right to left, the right end is the drain, and the left end is the source.

It may be understood in this way that the transistor Tr herein is a transistor device having three terminals. Therefore, the transistor Tr may be an NMOS (N-channel metal oxide semiconductor, N-channel metal oxide semiconductor) transistor, or may be a PMOS (P-channel metal oxide semiconductor, P-channel metal oxide semiconductor) transistor.

A memory cell 400 shown in FIG. 4 may be configured to store multi-bit data, to increase a storage capacity of each memory cell. In particular, the ferroelectric capacitor C1, the ferroelectric capacitor C2, and the ferroelectric capacitor C3 share one transistor Tr. In this way, a quantity of transistors of each memory cell 400 may be further reduced, to improve storage density.

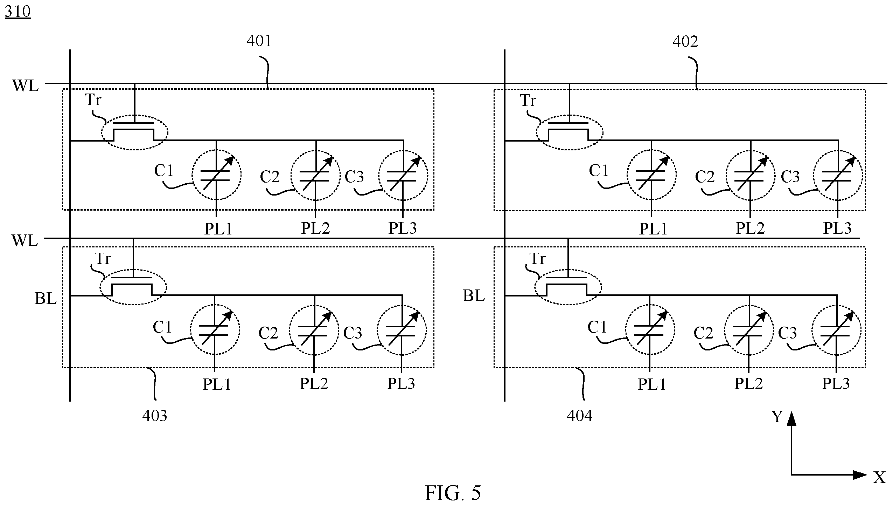

The memory array 310 may be obtained by arranging the memory cells 400 shown in FIG. 4 according to an array. Circuit structures of all the memory cells 400 are the same. For example, in the memory array 310 shown in FIG. 5, a memory array including four memory cells: a memory cell 401, a memory cell 402, a memory cell 403, and a memory cell 404 is provided as an example. A person skilled in the art may design an arrangement manner of the memory cells 400 in the memory array 310 and a quantity of memory cells 400 based on a storage capacity requirement of the memory 300.

In an implementation, the memory array 310 may further include more memory cells 400, and these memory cells 400 may be arranged in an X direction, a Y direction, and a Z direction that are perpendicular to each other, to form a three-dimensional memory array.

In an optional implementation, in the memory array 310 shown in FIG. 5, the word line WL extends in the X direction, so that control ends of transistors Tr of a plurality of memory cells arranged in the X direction are electrically connected to a same word line WL. Further, the bit line BL extends in the Y direction perpendicular to the X direction. In this way, first ends of transistors Tr of a plurality of memory cells arranged in the Y direction are electrically connected to a same bit line BL.

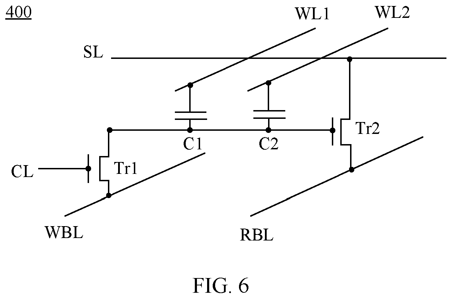

FIG. 6 is a diagram of a circuit structure of another memory cell 400 of the FRAM. The memory cell 400 includes a first transistor Tr1, a second transistor Tr2, and a plurality of ferroelectric capacitors (a ferroelectric capacitor C1 and a ferroelectric capacitor C2 shown in FIG. 6). Such a memory cell may be referred to as a 2TnC memory cell. The ferroelectric capacitor C2 and the ferroelectric capacitor C1 have a same structure, and each include two electrodes and a ferroelectric layer located between the two electrodes. For ease of clearly describing an electrical connection relationship between the ferroelectric capacitor C2 and the ferroelectric capacitor C1 and another structure, one electrode of the ferroelectric capacitor C1 may be referred to as a first electrode, the other electrode may be referred to as a second electrode, one electrode of the ferroelectric capacitor C2 may be referred to as a third electrode, and the other electrode may be referred to as a fourth electrode.

With reference to FIG. 6, the memory cell 400 further includes a word line (word line, WL), a write bit line (write bit line, WBL), a read bit line (read bit line, RBL), a source line (source line, SL), and a control line (control line, CL). A control end of the first transistor Tr1 is electrically connected to a control line CL, a first end of the first transistor Tr1 is electrically connected to the first electrode of the ferroelectric capacitor C1 and the third electrode of the ferroelectric capacitor C2, a second end of the first transistor Tr1 is electrically connected to the write bit line WBL, and the second electrode of the ferroelectric capacitor C1 and the fourth electrode of the ferroelectric capacitor C2 are electrically connected to a corresponding word line WL.

As shown in FIG. 6, a first end of the second transistor Tr2 is electrically connected to the source line SL, a second end is electrically connected to the read bit line RBL, and a control end of the second transistor T2 is electrically connected to the first electrode of the ferroelectric capacitor C1 and the third electrode of the ferroelectric capacitor C2.

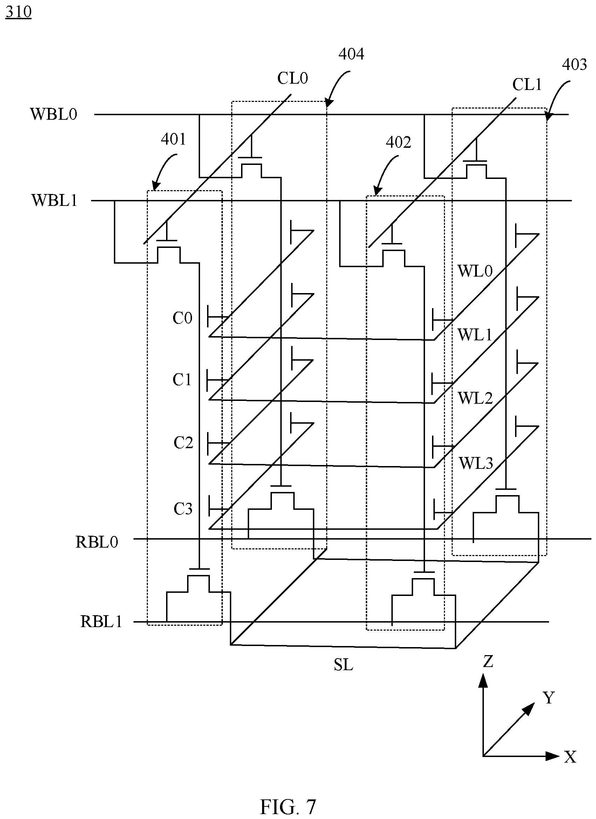

In an optional implementation, a memory array 310 shown in FIG. 7 may be obtained by arranging the memory cells 400 shown in FIG. 6 according to an array.

For example, in the memory array 310 shown in FIG. 7, a memory array including four memory cells: a memory cell 401, a memory cell 402, a memory cell 403, and a memory cell 404 is provided as an example.

The memory array 310 shown in FIG. 7 includes two control lines: a control line CL0 and a control line CL1, and each control line extends in a Y direction. When the memory array 310 further includes more memory cells, correspondingly, more control lines CLs are further included, and these control lines are arranged in parallel in an X direction perpendicular to the Y direction. In addition, a plurality of memory cells arranged in the Y direction may share one control line. For example, the memory cell 401 and the memory cell 404 share the selected control line CL0, and the memory cell 402 and the memory cell 403 share the control line CL1.

Still refer to FIG. 7. The memory array 310 includes two write bit lines: a write bit line WBL0 and a write bit line WBL1, and each write bit line extends in the X direction. When more write bit lines WBL are further included, these write bit lines WBL are arranged in parallel in the Y direction perpendicular to the X direction. In addition, a plurality of memory cells arranged in the X direction may share one write bit line WBL. For example, the memory cell 401 and the memory cell 402 share the write bit line WBL1, and the memory cell 403 and the memory cell 404 share the write bit line WBL0.

Similarly, the read bit line RBL and the write bit line WBL are disposed in a same manner. Details are not described herein.

It should be noted that, for a source line SL in the memory array, not only a plurality of memory cells arranged in the X direction share a source line SL, but also a plurality of memory cells arranged in the Y direction share a source line SL. For example, the memory cell 401 herein and the memory cell 404 share a source line SL, and the memory cell 401 and the memory cell 402 share a source line SL. In other words, source lines SLs of the memory cell 401, the memory cell 402, the memory cell 403, and the memory cell 404 are connected to each other. In an implementable process structure, a source line SL layer structure parallel to a substrate may be formed, so that source lines parallel to the substrate are electrically connected to each other.

In addition, it should be noted that, for the word line WL in the memory array, not only the plurality of memory cells arranged in the X direction share a word line WL, but also the plurality of memory cells arranged in the Y direction share a word line WL. For example, a ferroelectric capacitor C0 of the memory cell 401 and a ferroelectric capacitor C0 of the memory cell 402 are connected to a same word line WL0, the ferroelectric capacitor C0 of the memory cell 401 and a ferroelectric capacitor C0 of the memory cell 404 are also connected to a same word line WL0. In other words, word lines WL0 of the four ferroelectric capacitors C0 of the memory cell 401, the memory cell 402, the memory cell 403, and the memory cell 404 are connected to each other, and the word lines WL1 of the four ferroelectric capacitors C1 of the memory cell 401, the memory cell 402, and the memory cell 403, and the memory cell 404 are connected to each other. Similarly, in an implementable process structure, a word line layer structure parallel to the substrate may be disposed, so that word lines located at a same layer are connected to each other.

In the memory cell 400 of the memory array shown in FIG. 4, FIG. 5, FIG. 6, and FIG. 7, a ferroelectric capacitor structure may include a first electrode and a second electrode, and a ferroelectric layer formed between the first electrode and the second electrode. Alternatively, the ferroelectric capacitor is of a metal-ferroelectric-metal (metal-ferroelectric-metal, MFM) structure.

In comparison with a conventional ferroelectric material, a thickness of a hafnium oxide-based ferroelectric memory array including a ferroelectric layer of a hafnium oxide-based material may be miniaturized to 10 nanometers or even sub-ten nanometers. In this way, high-density integration and even three-dimensional integration can be implemented, and a unique advantage exists in constructing an ultra-high-density memory chip. In addition, a preparation process of the hafnium oxide-based ferroelectric memory array is well compatible with a mature silicon-based semiconductor process. Therefore, the hafnium oxide-based ferroelectric memory array is expected to become a core unit of a future new ferroelectric memory.

At present, one of biggest problems that restrict application of hafnium oxide-based ferroelectric memory arrays in commercial memory arrays is anti-disturbance (disturbance) performance of the hafnium oxide-based ferroelectric memory arrays. In a hafnium oxide-based ferroelectric memory chip, if a crossbar array structure (crossbar) is used, a plurality of hafnium oxide-based memory cells are connected through word lines WLs and bit lines BLs to form an array. When the memory chip needs to read or write data, a voltage needs to be applied to a word line WL and a bit line BL, to select, read, and write a specific hafnium oxide-based memory cell. Because the word line WL and the bit line BL in the memory chip are not completely independent, a voltage applied to a word line WL or a bit line BL causes disturbance to a hafnium oxide-based memory cell on a nearby line. This leads to ferroelectric polarization reversal of the related hafnium oxide-based ferroelectric memory cell under a disturbance voltage, so that information stored in the hafnium oxide-based ferroelectric memory cell is difficult to read or even lost. Therefore, how to enhance an anti-disturbance capability of the hafnium oxide-based memory cell in a read/write process is one of problems that urgently need to be resolved currently.

In a related technology, a solution to resolve a disturbance problem faced by the hafnium oxide-based memory cell in a read/write operation of the memory chip is: reducing disturbance caused by a read/write pulse to a non-target device by optimizing a pulse parameter and timing logic of the read/write operation.

For example, when an operating voltage Vcc is applied to select, read, and write a target memory cell, a voltage of 1/3 Vcc is applied to a non-target memory cell, to suppress disturbance caused by a voltage of a line in which the target memory cell is located to the non-target memory cell.

For example, when a voltage Vcc is applied to a word line WL of the target memory cell in each clock cycle, a voltage of 1/3 Vcc and a voltage of 2/3 Vcc are respectively applied to a word line WL and a bit line BL in which the non-target memory cell is located. When Vcc is applied to a bit line BL of the target memory cell, a voltage of 2/3 Vcc and a voltage of 1/3 Vcc are respectively applied to the word line WL and the bit line BL in which the non-target memory cell is located. Because relative potentials of the word line WL and the bit line BL change alternately, disturbance voltages of the word line WL and the bit line BL cause ferroelectric polarization reversal in different directions, to drive a ferroelectric polarization strength of the non-target memory cell to increase or decrease in different clock cycles and keep unchanged after a plurality of clock cycles. This reduces a loss of information stored in the non-target memory cell.

The foregoing solution mainly enhances the anti-disturbance capability of the memory cell from a circuit level, and has a specific requirement on the anti-disturbance performance of the memory cell. If the anti-disturbance performance of the memory cell is poor, the solution cannot be used. In addition, because a voltage is applied to the non-target memory cell in a read/write operation process, the non-target memory cell may be subject to unnecessary electric field stress, and durability performance of the non-target memory cell is reduced.

In view of this, an embodiment of this application further provides a memory array. A structure of a ferroelectric capacitor in the memory array is changed to suppress ferroelectric polarization reversal of a memory cell under a low electric field strength, to enhance anti-disturbance performance of the memory cell.

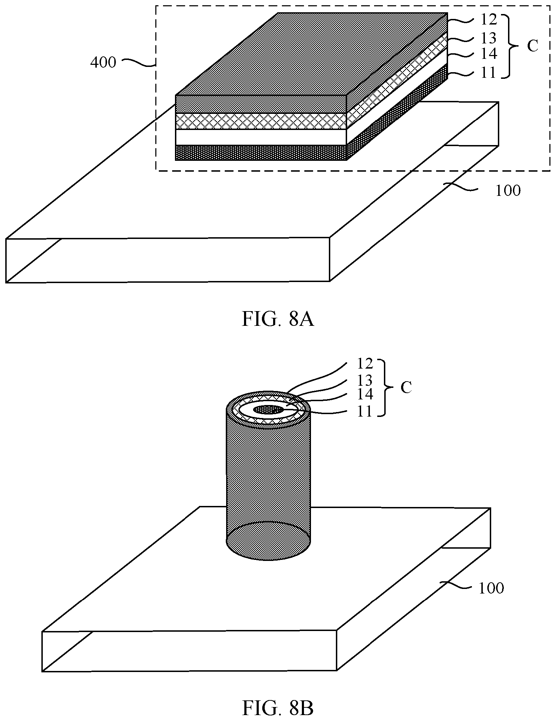

As shown in FIG. 8A, the memory array includes a substrate 100 and a memory cell 400 disposed on the substrate 100. The memory array includes a plurality of memory cells 400. In FIG. 8A, only one memory cell 400 is used as an example for illustration.

The memory cell 400 includes a transistor and a ferroelectric capacitor C. For ease of description, FIG. 8A shows only a structure of the ferroelectric capacitor C.

The ferroelectric capacitor C includes a first electrode 11 and a second electrode 12, and a ferroelectric layer 13 formed between the first electrode 11 and the second electrode 12. The ferroelectric capacitor C further includes at least one nonlinear resistor layer 14 (in FIG. 8A, one nonlinear resistor layer 14 is used as an example for illustration). In addition, the at least one nonlinear resistor layer 14 and the ferroelectric layer 13 are disposed between the first electrode 11 and the second electrode 12.

The first electrode 11 and the second electrode 12 are arranged in a direction perpendicular to a thickness direction of the second electrode 12, a surface that is of the first electrode 11 and that is perpendicular to the thickness direction is disposed opposite to a surface that is of the second electrode 12 and that is perpendicular to the thickness direction, the first electrode 11 and the second electrode 12 define gap space, and the nonlinear resistor layer 14 and the ferroelectric layer 13 are disposed in the gap space between the first electrode 11 and the second electrode 12. Alternatively, it is understood as that the first electrode 11 and the second electrode 12 are stacked, and the ferroelectric layer 13 and the nonlinear resistor layer 14 are stacked between the first electrode 11 and the second electrode 12.

In some embodiments, as shown in FIG. 8A, thickness directions of the first electrode 11 and the second electrode 12 are perpendicular to the substrate 100, and the first electrode 11 and the second electrode 12 in the ferroelectric capacitor C are disposed in a direction perpendicular to the substrate 100.

In other words, each structure of the first electrode 11, the second electrode 12, the ferroelectric layer 13, the at least one nonlinear resistor layer 14, and at least one third electrode 15 is arranged in parallel with the substrate 100. Such a ferroelectric capacitor C may be referred to as a planar ferroelectric capacitor structure.

In some other embodiments, as shown in FIG. 8B, the thickness directions of the first electrode 11 and the second electrode 12 are parallel to the substrate 100, and the first electrode 11 and the second electrode 12 are disposed in a direction parallel to the substrate 100.

Such a ferroelectric capacitor C may be referred to as a vertical ferroelectric capacitor structure. When the vertical capacitor structure is used, three-dimensional stacking may be implemented, to improve storage density and increase a storage capacity.

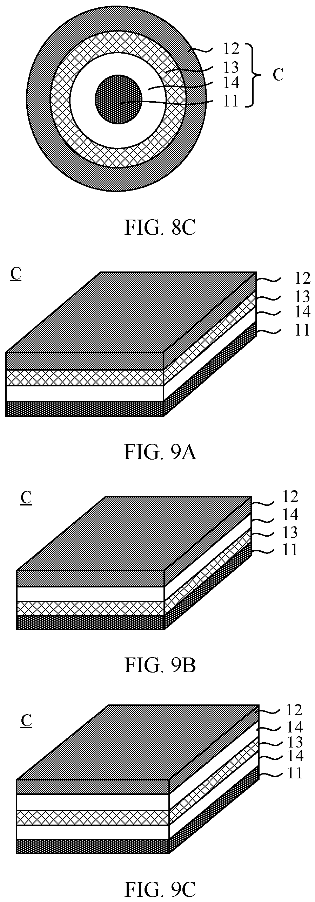

FIG. 8B shows an implementable structure of the vertical ferroelectric capacitor structure, and FIG. 8C is a top view of FIG. 8B.

Specifically, the first electrode 11 extends in the direction perpendicular to the substrate 100, and the ferroelectric layer 13, the at least one nonlinear resistor layer 14, the at least one third electrode 15, and the second electrode 12 sequentially surround a periphery of the first electrode 11 in the direction parallel to the substrate 100. In this way, a ferroelectric capacitor C of a column structure is formed.

A cross section of the ferroelectric capacitor C of the column structure may be a circle shown in FIG. 8C, or may be a rectangle, or may be another shape.

In some implementations, the first electrode 11 and the second electrode 12 may be made of a metalcontaining material.

For example, materials of the first electrode 11 and the second electrode 12 include metal, metal nitride, metal carbide, conductive metal nitride, conductive metal oxide, or a combination thereof.

For example, the material of the first electrode 11 may include titanium (Ti), titanium nitride (TiN), tantalum nitride (TaN), tungsten (W), tungsten nitride (WN), ruthenium (Ru), iridium (Ir), ruthenium oxide (RuO₂), iridium oxide (IrO₂), niobium nitride (NbN), molybdenum nitride (MoN), or a combination thereof.

The material of the second electrode 12 may include, for example, titanium (Ti), titanium nitride (TiN), tantalum nitride (TaN), titanium carbon nitride (TiCN), tantalum carbon nitride (TaCN), tungsten (W), tungsten nitride (WN), ruthenium (Ru), iridium (Ir), ruthenium oxide (RuO₂), niobium nitride (NbN), molybdenum nitride (MoN), iridium oxide (IrO₂), silicon (Si), germanium (Ge), silicon germanium (SiGe), or a combination thereof.

The materials of the first electrode 11 and the second electrode 12 may be the same, or may be different.

In some embodiments, thicknesses of the first electrode 11 and the second electrode 12 in a stacking direction may be but are not limited to 1 nm to 100 nm. In addition, the thickness of the first electrode 11 may be equal to or not equal to the thickness of the second electrode 12.

The ferroelectric layer 13 has ferroelectricity, so that the ferroelectric layer 13 has spontaneous polarization within a specific temperature range, and a spontaneous polarization direction of the ferroelectric layer 13 may be reversed due to a reverse direction of an external electric field. In this way, when the polarization direction of the ferroelectric capacitor is reversed, the ferroelectric capacitor C is charged and discharged, which can be identified by an external circuit, to implement a "0" or "1" storage state.

In some embodiments, the ferroelectric layer 13 is made of a hafnium oxide-based material. In comparison with another ferroelectric material, a thickness size of the hafnium oxide-based ferroelectric capacitor C may be miniaturized to 10 nanometers or even sub-ten nanometers. In this way, high-density integration and even three-dimensional integration can be implemented, and a large advantage of the hafnium oxide-based ferroelectric capacitor C exists in constructing an ultra-high-density memory chip. In addition, a preparation process of the hafnium oxide-based ferroelectric capacitor C may be well compatible with a silicon-based semiconductor process. In this way, the ferroelectric capacitor C may be prepared by using a mature manufacturing process, and manufacturing costs are not increased.

For example, the hafnium oxide-based material may be a ferroelectric material that is based on a hafnium oxide (hafnium oxide, HfO) material system. For example, a material of the ferroelectric layer 13 may be zirconium (Zr)-doped hafnium dioxide (HfO₂), silicon (Si)-doped HfO₂, aluminum (Al)-doped HfO₂, lanthanum (La)-doped HfO₂, Yttrium (Y)-doped HfO₂, gadolinium (Gd)-doped HfO₂, strontium (Sr)-doped HfO₂, and the like.

Alternatively, the hafnium oxide-based material may be a ferroelectric material in a hafnium zirconium oxide (hafnium zirconium oxide, HZO) material system. For example, the material of the ferroelectric layer 13 may be lanthanum (La)-doped HZO, yttrium (Y)-doped HZO, strontium (Sr)-doped HZO, gadolinium (Gd)-doped HZO, gadolinium/lanthanum (Gd/La)-doped HZO, and the like. Alternatively, a doped element may be one or more of nitrogen, iron, lutetium, praseodymium, germanium, scandium, cerium, neodymium, magnesium, barium, indium, gallium, calcium, and carbon.

Alternatively, the hafnium oxide-based material may be a ferroelectric material in material systems such as hafnium silicon oxygen, hafnium aluminum oxygen, hafnium lanthanum oxygen, hafnium zirconium lanthanum oxygen, hafnium zirconium cerium oxygen, hafnium zirconium yttrium oxygen, and hafnium zirconium gadolinium oxygen.

In some scenarios, the first electrode 11 and the second electrode 12 may be prepared by using titanium nitride TiN, and the ferroelectric layer 13 may be prepared by using zirconium (Zr)-doped hafnium dioxide (HZO), to make full use of a characteristic that tensile stress provided by an HZO layer is conducive to forming a ferroelectric phase and a characteristic that a TiN material can be compatible with a semiconductor CMOS process.

In some embodiments, the first electrode 11 and the second electrode 12 may be prepared by using titanium nitride (TiN), and the ferroelectric layer 13 may be prepared by using zirconium (Zr)-doped hafnium dioxide (HZO), to make full use of the characteristic that tensile stress provided by the HZO layer is conducive to forming the ferroelectric phase and the characteristic that the TiN material can be compatible with the semiconductor CMOS process.

In addition, thickness of the ferroelectric layer 13 in the stacking direction may be but is not limited to 1 nm to 100 nm.

A crystal in the ferroelectric phase is formed in the ferroelectric layer 13, and when an electric field is applied to the ferroelectric layer 13, a central atom of the crystal stops in a low-energy state in the electric field. When electric field reversal is applied to the ferroelectric layer, the central atom moves in the crystal in a direction of the electric field and stops in another low-energy state. A large quantity of central atoms move and are coupled in a crystal cell to form a ferroelectric domain (ferroelectric domain). The ferroelectric domain forms a polarization charge under an action of the electric field, and polarization charges formed by the ferroelectric domain before and after electric field reversal are different in energy. In this binary stable state, the ferroelectric capacitor C is charged and discharged, which can be identified by the external circuit to implement the "0" or "1" storage state.

For the nonlinear resistor layer 14, in a possible implementation, as shown in FIG. 9A, the nonlinear resistor layer 14 is disposed on at least one side of the ferroelectric layer 13.

In some embodiments, as shown in FIG. 9A, the ferroelectric capacitor C includes one nonlinear resistor layer 14, and the nonlinear resistor layer 14 is disposed on one side of the ferroelectric layer 13.

Therefore, for example, as shown in FIG. 9A, the nonlinear resistor layer 14 is disposed between the ferroelectric layer 13 and the first electrode 11.

Alternatively, for example, as shown in FIG. 9B, the nonlinear resistor layer 14 is disposed between the ferroelectric layer 13 and the second electrode 12.

In some other embodiments, as shown in FIG. 9C, the ferroelectric capacitor C includes a plurality of nonlinear resistor layers 14, and the nonlinear resistor layer 14 is disposed on at least one side of the ferroelectric layer 13.

Therefore, for example, as shown in FIG. 9C, at least one nonlinear resistor layer 14 is disposed between the ferroelectric layer 13 and the first electrode 11, and at least one nonlinear resistor layer 14 is also disposed between the ferroelectric layer 13 and the second electrode 12.

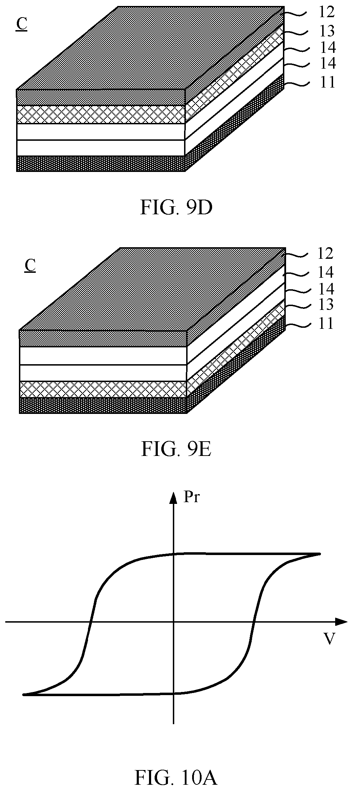

Alternatively, for example, as shown in FIG. 9D, a plurality of nonlinear resistor layers 14 are disposed between the ferroelectric layer 13 and the first electrode 11.

Alternatively, for example, as shown in FIG. 9E, a plurality of nonlinear resistor layers 14 are disposed between the ferroelectric layer 13 and the second electrode 12.

A material of the nonlinear resistor layer 14 has a characteristic that a resistance of the material of the nonlinear resistor layer 14 nonlinearly decreases as an applied voltage increases.

In other words, when a voltage is applied to two ends of the nonlinear resistor layer 14 that is made of the foregoing material having the characteristic that the resistance nonlinearly decreases as the applied voltage increases, the resistance of the material in the nonlinear resistor layer 14 nonlinearly decreases, and a resistance of the nonlinear resistor layer 14 nonlinearly decreases.

It can be learned from the descriptions in FIG. 4 and FIG. 6 that the first electrode 11 and the second electrode 12 of the ferroelectric capacitor C are used as voltage receive ends to receive a voltage applied by a signal line (for example, a bit line BL and a plate line PL, or a word line WL and a write bit line WBL). In this case, the characteristic of the material of the nonlinear resistor layer 14 makes the nonlinear resistor layer 14 to have a characteristic that the resistance of the nonlinear resistor layer 14 nonlinearly decreases as a voltage applied to the ferroelectric capacitor C increases. Alternatively, it is understood as that, a slope of a resistance curve of the nonlinear resistor layer 14 nonlinearly increases as the voltage applied to the ferroelectric capacitor C increases.

The nonlinear decrease may be understood as that the voltage applied to the ferroelectric capacitor C linearly increases, but the resistance of the nonlinear resistor layer 14 slowly decreases and then rapidly decreases. In other words, the resistance of the nonlinear resistor layer 14 shows a nonlinear change as the applied voltage increases. When the applied voltage is small, the resistance of the nonlinear resistor layer 14 is large. When the applied voltage is large, the resistance of the nonlinear resistor layer 14 rapidly decreases.

For example, in a case in which the voltage applied to the ferroelectric capacitor C is within 1/2 Vcc, the resistance of the nonlinear resistor layer 14 hardly decreases. When the voltage applied to the ferroelectric capacitor C is greater than 1/2 Vcc, the resistance of the nonlinear resistor layer 14 rapidly decreases. Vcc is a voltage applied by the read/write operation.

Refer to FIG. 9E. The ferroelectric layer 13 and the nonlinear resistor layer 14 are disposed in parallel and stacked. In this case, the ferroelectric layer 13 and the nonlinear resistor layer 14 belong to a series connection relationship, and the ferroelectric layer 13 and the nonlinear resistor layer 14 may be equivalent to two resistors connected in series.

Based on this, for an unselected memory cell, due to disturbance from a selected memory cell, a voltage less than Vcc (for example, less than 1/3 Vcc) is applied to a ferroelectric capacitor C in the unselected memory cell. In this case, the resistance of the nonlinear resistor layer 14 is large, and after the ferroelectric layer 13 and the nonlinear resistor layer 14 perform voltage division on 1/3 Vcc, a voltage applied to the ferroelectric layer 13 significantly decreases. At a low voltage, a polarization charge output by the ferroelectric capacitor C is almost zero. Therefore, disturbance of the "voltage less than Vcc" has little impact on a storage status of the memory cell, and the anti-disturbance performance of the memory cell is enhanced. At a next moment, after the unselected memory cell is selected, a Vcc voltage is applied to the ferroelectric capacitor C in the memory cell. In this case, the nonlinear resistor layer 14 rapidly decreases, and can be almost ignored. After the ferroelectric layer 13 and the nonlinear resistor layer 14 perform voltage division on Vcc, the voltage applied to the ferroelectric layer 13 is almost equal to Vcc. At a high voltage, the ferroelectric capacitor C outputs the polarization charge.

FIG. 10A is an electrical characteristic curve of a hafnium oxide-based memory cell that does not include the nonlinear resistor layer 14 (typical). A horizontal coordinate is a voltage V, and a vertical coordinate is a remnant polarization strength Pr. When a positive electric field is applied, a polarization strength of a memory cell in a direction of the positive electric field slowly increases, then rapidly increases, and finally slowly becomes saturated as the positive electric field is strengthened. When a negative electric field is applied, a polarization strength of the memory cell in a direction of the negative electric field slowly increases, then rapidly increases, and finally slowly becomes saturated as the negative electric field is strengthened.

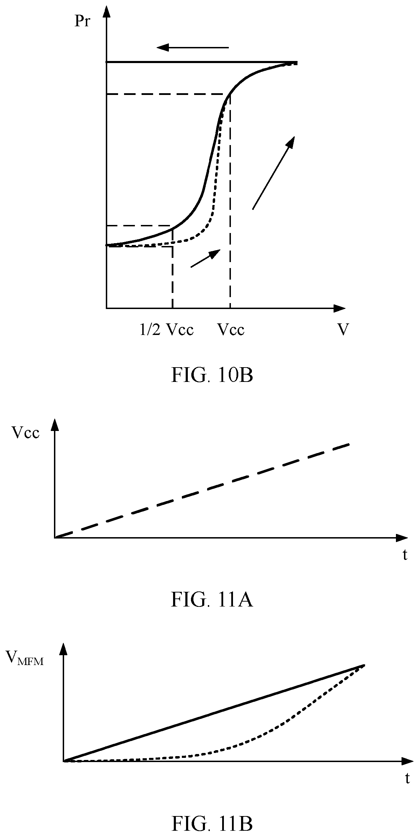

FIG. 10B shows a relationship between an electrical characteristic and anti-disturbance performance of a hafnium oxide-based memory cell including the nonlinear resistor layer 14 when a positive electric field is applied, and the relationship is similar to that in a negative electric field. A solid line in FIG. 10B is an electrical output characteristic of a hafnium oxide-based memory cell that does not include the nonlinear resistor layer 14 (typical), and a dashed line in FIG. 10B is an electrical output characteristic of a hafnium oxide-based memory cell that includes the nonlinear resistor layer 14.

It can be seen that, when an electric field is applied, even if the electric field is very small, ferroelectric polarization reversal of the hafnium oxide-based memory cell that does not include the nonlinear resistor layer 14 (typical) already starts. As the voltage rises to 1/2 Vcc, a specific amount of the ferroelectric polarization reversal of the memory cell is obtained, that is, a disturbance voltage of 1/2 Vcc has significant impact on a storage status of a device.

When an electric field is applied, ferroelectric polarization reversal of the hafnium oxide-based memory cell that includes the nonlinear resistor layer 14 also starts. However, as the voltage rises to 1/2 Vcc, the remnant polarization strength Pr slowly increases or almost does not increase. As the voltage rises to be greater than 1/2 Vcc, the remnant polarization strength Pr rapidly increases. In this way, at a low voltage (less than 1/2 Vcc), a polarization charge output by the memory cell is almost zero. Therefore, a disturbance voltage of a small voltage has little impact on the storage status of the memory cell, and the anti-disturbance performance of the memory cell is enhanced.

Therefore, according to the memory array provided in embodiments of this application, the nonlinear resistor layer 14 disposed parallel to the ferroelectric layer 13 is inserted into the ferroelectric capacitor C, so that the nonlinear resistor layer 14 and the ferroelectric layer 13 perform voltage division on the voltage applied to the ferroelectric capacitor C. The material of the nonlinear resistor layer 14 has the characteristic that the resistance nonlinearly decreases as the applied voltage increases, so that the resistance of the nonlinear resistor layer 14 nonlinearly decreases as the applied voltage increases. Therefore, after the nonlinear resistor layer 14 is placed in the ferroelectric capacitor C, the resistance of the nonlinear resistor layer 14 nonlinearly decreases as the voltage applied to the ferroelectric capacitor C increases, and a divided voltage obtained by the nonlinear resistor layer 14 nonlinearly decreases. Correspondingly, the divided voltage obtained by the ferroelectric layer 13 nonlinearly increases as the voltage applied to the ferroelectric capacitor C increases. In other words, when the voltage applied to the ferroelectric capacitor C is small, a proportion of the divided voltage obtained by the ferroelectric layer 13 is small. When the voltage applied to the ferroelectric capacitor C is large, the proportion of the divided voltage obtained by the ferroelectric layer 13 is large. In this case, ferroelectric polarization reversal of the ferroelectric capacitor C also has the characteristic of a nonlinear change with a voltage change. In other words, when the voltage applied to the ferroelectric capacitor C is small (a disturbance voltage), the proportion of the divided voltage obtained by the ferroelectric layer 13 is small, and a ferroelectric polarization reversal amount of the ferroelectric capacitor C is small, which has little impact on the storage status of the memory cell. When the voltage applied to the ferroelectric capacitor C is large (a read/write voltage), the proportion of the divided voltage obtained by the ferroelectric layer 13 is large, and the ferroelectric polarization reversal amount of the ferroelectric capacitor C is large, so that a read/write operation can be normally completed. In this way, existence of the nonlinear resistor layer 14 may regulate a voltage response characteristic of the memory cell, and enhance a nonlinear response characteristic that is of the memory cell and that is obtained when the voltage increases, to suppress ferroelectric polarization reversal that is at a low voltage and that is of the ferroelectric capacitor C, and effectively enhance anti-disturbance performance of the memory cell.

For the material of the nonlinear resistor layer 14, in a first possible implementation, the material of the nonlinear resistor layer 14 is a conductive material, and the material of the nonlinear resistor layer 14 has a resistive switching characteristic.

The resistive switching characteristic may be understood as that a resistance of the material of the nonlinear resistor layer 14 is not a fixed value, and changes with the voltage.

In some embodiments, the material of the nonlinear resistor layer 14 includes a transition metal oxide.

The transition metal oxide (transition metal oxide) is an oxide including a transition metal.

For example, the material of the nonlinear resistor layer 14 includes at least one of tantalum oxide (Ta₂O₅), niobium oxide (Nb₂O₅), titanium dioxide (TiO₂), or hafnium dioxide (HfO₂).

It should be emphasized herein that, it can be learned from the foregoing description of the material of the ferroelectric layer 13 that, when the material of the ferroelectric layer 13 is a material of a HfO material system, the ferroelectric layer 13 is doped with the HfO₂. Therefore, when the material of the nonlinear resistor layer 14 includes the HfO₂, a doped component in a film layer may be analyzed, to divide a boundary of a film layer of the ferroelectric layer 13 and a boundary of a film layer of the nonlinear resistor layer 14.

In some other embodiments, the material of the nonlinear resistor layer 14 includes a lanthanum oxide.

The lanthanum oxide is an oxide including a lanthanum element.

For example, the material of the nonlinear resistor layer 14 includes a lanthanum oxide (La₂O₃) and a praseodymium oxide (Pr₆O₁₁).

In some other embodiments, the material of the nonlinear resistor layer 14 includes a perovskite composite oxide.

A general formula of the perovskite composite oxide is ABO₃. The perovskite composite oxide is a new inorganic non-metallic material with unique physical and chemical properties. A is generally rare earth or alkaline earth element ion, and B is transition element ion. Both A and B can be partially replaced by other metal ions with similar radiuses to keep crystal structures of A and B basically unchanged.

For example, the material of the nonlinear resistor layer 14 includes doped strontium titanate (SrTiO₃), barium titanate (BaTiO₃), and lanthanum manganese (LaMnO₃).

In some other embodiments, the material of the nonlinear resistor layer 14 includes an organic polymer.

The organic polymer refers to a macromolecule that includes one or more organic molecules or molecular groups that are covalently bonded and that includes a plurality of repeating monomer units.

For example, the material of the nonlinear resistor layer 14 includes polyethylene methacrylate (polyethyl methacrylate, PEMA), polyazomethine (Polyazomethine, PAM), polytriphenylamine (polytriphenylamine, PTPA), or poly[2,7-(9,9-dihexylfluorene)]-block-polypendentisoindigo (poly[2,7-(9,9-dihexylfluorene)]-block-polypendentisoindigo, PF₁₄-b-Pisoₙ).

For the material with the resistive switching characteristic, an oxygen vacancy channel or a metal ion channel is formed or cut off when the externally applied voltage changes.

For example, when the voltage is small, the oxygen vacancy channel or the metal ion channel is slowly formed, and the resistance of the nonlinear resistor layer 14 is large. When the voltage is large, the oxygen vacancy channel or the metal ion channel is quickly formed, and the resistance of the nonlinear resistor layer 14 rapidly decreases.

Therefore, the material of the nonlinear resistor layer 14 has the resistive switching characteristic, and the resistance of the nonlinear resistor layer 14 changes as the voltage changes. Further, a material whose resistive switching characteristic is that the resistance nonlinearly decreases as the voltage increases is selected, so that the resistance of the material of the nonlinear resistor layer 14 nonlinearly decreases as the voltage applied to the ferroelectric capacitor C increases.

As shown in FIG. 11A, the voltage Vcc applied to the ferroelectric capacitor C changes linearly with time.

FIG. 11B is a curve of the voltage of the ferroelectric layer 13 changing with time as the applied voltage Vcc increases. A solid line is a voltage change curve that is of the ferroelectric layer 13 and that is obtained when the nonlinear resistor layer 14 is not disposed. A dashed line is a voltage change curve that is of the ferroelectric layer 13 and that is obtained after the nonlinear resistor layer 14 is disposed. At a low voltage, a resistance of the nonlinear resistor layer 14 is large, and a proportion of a divided voltage is large. Therefore, a divided voltage obtained by the ferroelectric layer 13 is small. The resistance of the nonlinear resistor layer 14 rapidly decreases as the voltage increases, and the divided voltage obtained by the ferroelectric layer 13 abruptly increases. Therefore, the voltage of the ferroelectric layer 13 presents a nonlinear change characteristic with time.

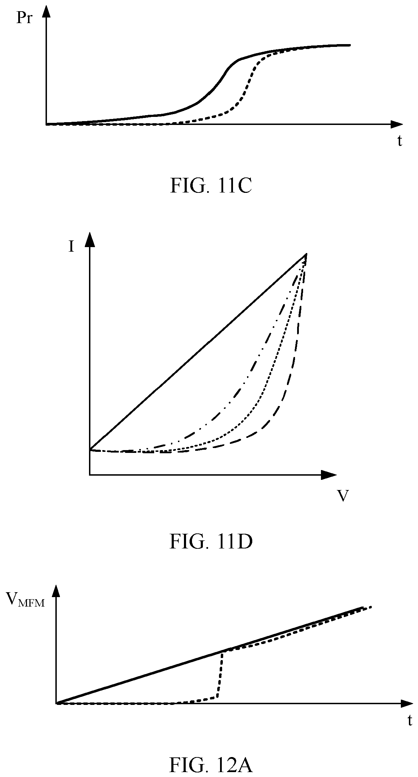

FIG. 11C is a curve of the remnant polarization strength Pr of the ferroelectric layer 13 changing with time. A solid line is a change curve that is of the remnant polarization strength Pr and that is obtained when the nonlinear resistor layer 14 is not inserted, and a dashed line is a change curve that is of the remnant polarization strength Pr and that is obtained after the nonlinear resistor layer 14 is inserted. After the nonlinear resistor layer 14 is inserted, the voltage of the ferroelectric layer 13 nonlinearly changes with time.

Therefore, as shown in FIG. 11D, after the nonlinear resistor layer 14 having the resistive switching characteristic is inserted into the ferroelectric capacitor C, a polarization charge output of the ferroelectric capacitor C nonlinearly changes with the voltage. When a total voltage is small, a divided voltage obtained by the ferroelectric layer 13 is small, a ferroelectric polarization reversal amount of the ferroelectric layer 13 is small, and an output current of the ferroelectric capacitor C is small, so that the anti-disturbance capability of the memory cell can be effectively enhanced. However, when the total voltage is large, the resistance of the nonlinear resistor layer 14 abruptly decreases, the divided voltage obtained by the ferroelectric layer 13 abruptly increases, and the output current of the ferroelectric capacitor C abruptly increases, so that sufficient ferroelectric polarization reversal occurs in the ferroelectric layer 13.

In some embodiments, a nonlinear characteristic of the nonlinear resistor layer 14 may be adjusted by adjusting factors such as thickness, a quantity, and a location of the nonlinear resistor layer 14. FIG. 11D is an output characteristic curve of the ferroelectric capacitor C. In FIG. 11D, a solid line indicates that the polarization charge output of the ferroelectric capacitor C linearly changes as the voltage changes, and is used as a reference. A two-point long dashed line, a dotted line, and a dashed line indicate that the polarization charge output of the ferroelectric capacitor C nonlinearly changes as the voltage changes, and nonlinear characteristics of the two-point long dashed line, the dotted line, and the dashed line are gradually enhanced, to enhance the anti-disturbance capability of the memory cell.

In a second possible implementation, the material of the nonlinear resistor layer 14 has a metal-insulator transition characteristic.

The metal-insulator transition (metal-insulator transition) refers to physical transition from a metal conductor to a non-conductive insulator (or semiconductor), or physical transition from an insulator to a conductor. With reference to the characteristic of the material of the nonlinear resistor layer 14 that the resistance nonlinearly decreases as the voltage increases, the material of the nonlinear resistor layer 14 in embodiments of this application has the characteristic that the material of the nonlinear resistor layer 14 is an insulator at a low voltage and is a metal at a high voltage.

In some embodiments, the material of the nonlinear resistor layer 14 includes a solid electrolyte.

The solid electrolyte is an object that presents ion conductivity in a solid state (that is, below a melting point).

For example, the material of the nonlinear resistor layer 14 includes sulfide such as germanium sulfide (GeₓS_{y}), silver sulfide (Ag₂S), and copper sulfide (Cu₂S), iodide such as silver iodide (AgI) and rubidium silver iodide (RbAg₄I₅), selenide such as germanium selenide (GeₓSe_{y}), and telluride such as germanium telluride (GeₓTe_{y}), antimony telluride (SbₓTe_{y}), germanium-antimony-tellurium (GeSbTe), and silver-indium-antimony-tellurium (AgInSbTe).

Because of the material having the metal-insulator transition characteristic, in a case in which an externally applied voltage changes, Joule heat also changes, so that phase transition occurs in the material of the nonlinear resistor layer 14, to implement interchange transition between an insulator phase and a metal phase.

For example, when the voltage is small, the Joule heat is small, the material of the nonlinear resistor layer 14 is mainly the insulator phase, and the resistance of the nonlinear resistor layer 14 is large. When the voltage is large, the Joule heat increases, and phase transition occurs in the material of the nonlinear resistor layer 14. The nonlinear resistor layer 14 is mainly the metal phase, the material of the nonlinear resistor layer 14 changes from the insulator phase to the metal phase, and the resistance of the material of the nonlinear resistor layer 14 abruptly decreases.

Therefore, the material of the nonlinear resistor layer 14 has the metal-insulator transition characteristic, and the resistance of the material of the nonlinear resistor layer 14 changes as the voltage changes. Further, a material whose metal-insulator transition characteristic is that the material changes from an insulator to a metal as the voltage increases is selected, so that the resistance of the material of the nonlinear resistor layer 14 nonlinearly decreases, and the resistance of the nonlinear resistor layer 14 nonlinearly decreases as the voltage applied to the ferroelectric capacitor C increases.

As shown in FIG. 11A, the voltage Vcc applied to the ferroelectric capacitor C changes linearly with time.

FIG. 12A is a curve of the voltage of the ferroelectric layer 13 changing with time as the applied voltage Vcc increases. A solid line is a voltage change curve that is of the ferroelectric layer 13 and that is obtained when the nonlinear resistor layer 14 is not disposed, and a dashed line is a voltage change curve that is of the ferroelectric layer 13 and that is obtained after the nonlinear resistor layer 14 is disposed. At a low voltage, a resistance of the nonlinear resistor layer 14 is large, and a proportion of a divided voltage is large. Therefore, a divided voltage obtained by the ferroelectric layer 13 is small. As the voltage increases, phase transition occurs on the nonlinear resistor layer 14, and the nonlinear resistor layer 14 changes from an insulator to a metal phase. The resistance of the nonlinear resistor layer 14 rapidly decreases, and the divided voltage obtained by the ferroelectric layer 13 abruptly increases. Therefore, the voltage of the ferroelectric layer 13 presents a nonlinear change characteristic with time.

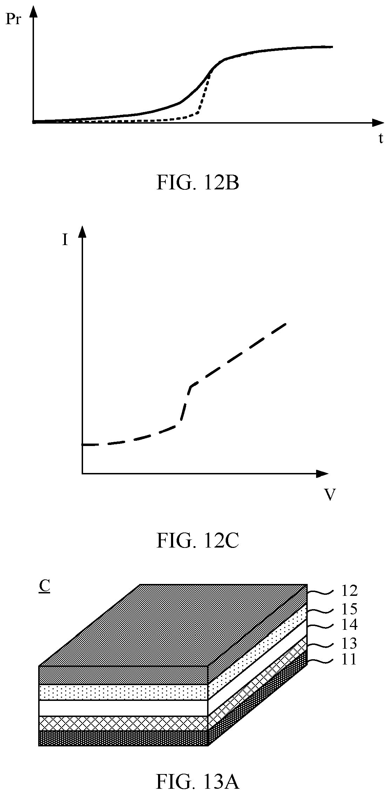

FIG. 12B is a curve of the remnant polarization strength Pr of the ferroelectric layer 13 changing with time. A solid line is a change curve that is of the remnant polarization strength Pr and that is obtained when the nonlinear resistor layer 14 is not inserted, and a dashed line is a change curve that is of the remnant polarization strength Pr and that is obtained after the nonlinear resistor layer 14 is inserted. After the nonlinear resistor layer 14 is inserted, the voltage of the ferroelectric layer 13 nonlinearly changes with time.

Therefore, as shown in FIG. 12C, after the nonlinear resistor layer 14 having the metal-insulator transition characteristic is inserted into the ferroelectric capacitor C, a polarization charge output of the ferroelectric capacitor C nonlinearly changes with the voltage. When a total voltage is small, a divided voltage obtained by the ferroelectric layer 13 is small, a ferroelectric polarization reversal amount of the ferroelectric layer 13 is small, and an output current of the ferroelectric capacitor C is small, so that the anti-disturbance capability of the memory cell can be effectively enhanced. However, when the total voltage is large and exceeds a critical voltage for phase transition of the nonlinear resistor layer 14, the resistance of the nonlinear resistor layer 14 abruptly decreases, the divided voltage obtained by the ferroelectric layer 13 abruptly increases, and the output current of the ferroelectric capacitor C abruptly increases, so that sufficient ferroelectric polarization reversal occurs in the ferroelectric layer 13.

In some embodiments, the ferroelectric capacitor C further includes at least one third electrode, and the at least one third electrode is disposed between the first electrode 11 and the second electrode 12.

In a possible implementation, as shown in FIG. 13A, the ferroelectric capacitor C further includes a third electrode 15.

In this case, the ferroelectric capacitor C includes two capacitors connected in series, and two electrodes of one capacitor are the first electrode 11 and the third electrode 15. In this embodiment of this application, the capacitor with the two electrodes being the first electrode 11 and the third electrode 15 is referred to as a lower capacitor. Two electrodes of the other capacitor are the second electrode 12 and the third electrode 15. In this embodiment of this application, the capacitor with the two electrodes being the second electrode 12 and the third electrode 15 is referred to as an upper capacitor. At least one of the upper capacitor and the lower capacitor is a ferroelectric capacitor.

In some embodiments, as shown in FIG. 13A, the nonlinear resistor layer 14 and the ferroelectric layer 13 are in contact and stacked.

For example, the nonlinear resistor layer 14 and the ferroelectric layer 13 are disposed between the first electrode 11 and the third electrode 15.

In other words, both the nonlinear resistor layer 14 and the ferroelectric layer 13 are located in the lower capacitor, and the nonlinear resistor layer 14 and the ferroelectric layer 13 are in contact and connected in series.

The ferroelectric layer 13 shown in FIG. 13A may be disposed close to the first electrode 11, or the nonlinear resistor layer 14 may be disposed close to the first electrode 11.

Alternatively, for example, the nonlinear resistor layer 14 and the ferroelectric layer 13 are disposed between the second electrode 12 and the third electrode 15.

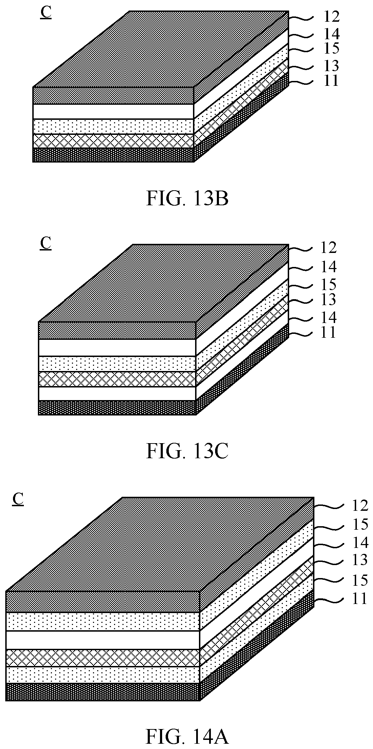

In other embodiments, as shown in FIG. 13B, the third electrode 15 is disposed between the nonlinear resistor layer 14 and the ferroelectric layer 13.

For example, as shown in FIG. 13B, the nonlinear resistor layer 14 is disposed between the second electrode 12 and the third electrode 15, and the ferroelectric layer 13 is disposed between the first electrode 11 and the third electrode 15.

In other words, the nonlinear resistor layer 14 is disposed in the upper capacitor, the ferroelectric layer 13 is disposed in the lower capacitor, and the nonlinear resistor layer 14 and the ferroelectric layer 13 are connected in series through the third electrode 15.

Alternatively, for example, the nonlinear resistor layer 14 is disposed between the first electrode 11 and the third electrode 15, and the ferroelectric layer 13 is disposed between the second electrode 12 and the third electrode 15.

The nonlinear resistor layer 14 and the ferroelectric layer 13 are disposed at an interval, so that impact of the nonlinear resistor layer 14 on ferroelectric polarization of the ferroelectric layer 13 can be reduced.

In FIG. 13A and FIG. 13B, examples in which the ferroelectric capacitor C includes one nonlinear resistor layer 14 are used. As shown in FIG. 13C, the ferroelectric capacitor C may alternatively include a plurality of nonlinear resistor layers 14. The plurality of nonlinear resistor layers 14 are properly disposed as required, and the plurality of nonlinear resistor layers 14 need to be located between the first electrode 11 and the second electrode 12.

In another possible implementation, as shown in FIG. 14A, the ferroelectric capacitor C further includes a plurality of third electrodes 15.

In this case, the ferroelectric capacitor C includes two or more capacitors connected in series, and two electrodes of one capacitor are the first electrode 11 and the third electrode 15. In this embodiment of this application, the capacitor with the two electrodes being the first electrode 11 and the third electrode 15 is referred to as a lower capacitor. Two electrodes of one capacitor are the second electrode 12 and the third electrode 15. In this embodiment of this application, the capacitor with the two electrodes being the second electrode 12 and the third electrode 15 is referred to as an upper capacitor. There is at least one capacitor with two electrodes being two adjacently disposed third electrodes 15. In this embodiment of this application, the capacitor with the two electrodes both being the third electrodes 15 is referred to as a middle capacitor. At least one of the upper capacitor, the at least one middle capacitor, and the lower capacitor is a ferroelectric capacitor.

In some embodiments, as shown in FIG. 14A, the nonlinear resistor layer 14 and the ferroelectric layer 13 are in contact and stacked.

For example, the nonlinear resistor layer 14 and the ferroelectric layer 13 are located between the two third electrodes 15.

Alternatively, for example, the nonlinear resistor layer 14 and the ferroelectric layer 13 are located between the first electrode 11 and the third electrode 15.

Alternatively, for example, the nonlinear resistor layer 14 and the ferroelectric layer 13 are located between the second electrode 12 and the third electrode 15.

Certainly, regardless of the structure, the nonlinear resistor layer 14 may be located on a side that is of the ferroelectric layer 13 and that is close to the first electrode 11, or the nonlinear resistor layer 14 may be located on a side that is of the ferroelectric layer and that is close to the second electrode 12.

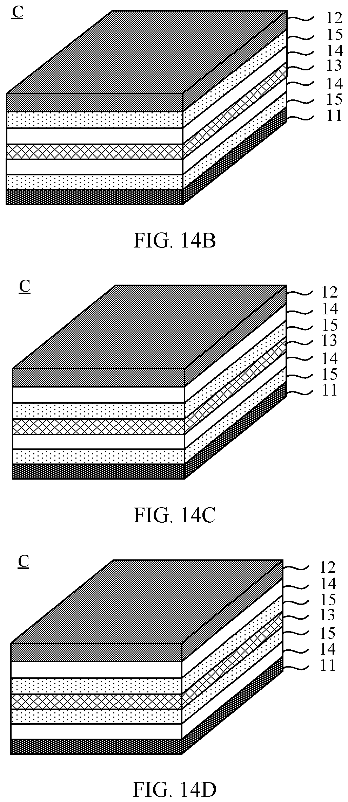

Alternatively, for example, as shown in FIG. 14B, the nonlinear resistor layers 14 and the ferroelectric layer 13 are in contact and stacked, and the nonlinear resistor layers 14 are disposed on both sides of the ferroelectric layer 13.

Alternatively, for example, as shown in FIG. 14C, one nonlinear resistor layer 14 and the ferroelectric layer 13 are in contact and stacked, and the third electrode 15 is disposed between another nonlinear resistor layer 14 and the ferroelectric layer 13

In other embodiments, as shown in FIG. 14D, the third electrode 15 is disposed between the nonlinear resistor layer 14 and the ferroelectric layer 13.

Alternatively, it is understood as that the nonlinear resistor layer 14 and the ferroelectric layer 13 are located in different capacitors.

For example, as shown in FIG. 14D, the ferroelectric layer 13 is located between two third electrodes 15.

Alternatively, for example, the ferroelectric layer 13 is located between the first electrode 11 and the third electrode 15.

Alternatively, for example, the ferroelectric layer 13 is located between the second electrode 12 and the third electrode 15.

Location relationships between the nonlinear resistor layer 14 and the ferroelectric layer 13 shown in FIG. 14A to FIG. 14D are merely examples, and are not limited thereto. The ferroelectric layer 13, at least one nonlinear resistor layer 14, and at least one third electrode 15 need to be disposed between the first electrode 11 and the second electrode 12.

An embodiment of this application further provides a memory array preparation method. In the memory array preparation method, a plurality of memory cells are formed on a substrate, and each memory cell includes any one of the foregoing ferroelectric capacitors C.

For a structure of the ferroelectric capacitor C, refer to the foregoing related descriptions of the ferroelectric capacitor C.

For example, the ferroelectric capacitor C includes a first electrode 11 and a second electrode 12, a ferroelectric layer 13 and at least one nonlinear resistor layer 14 that are disposed between the first electrode 11 and the second electrode 12. A material of the nonlinear resistor layer 14 has a characteristic that a resistance nonlinearly decreases as an applied voltage increases.

In some embodiments, a material of the nonlinear resistor layer 14 is a conductive material having a resistive switching characteristic.

For example, the material of the nonlinear resistor layer 14 includes a transition metal oxide.

For example, the material of the nonlinear resistor layer 14 includes at least one of Ta₂O₅, Nb₂O₅, TiO₂, or HfO₂.

Alternatively, for example, the material of the nonlinear resistor layer 14 includes a lanthanum oxide.

For example, the material of the nonlinear resistor layer 14 includes La₂O₃ and Pr₆O₁₁.

Alternatively, for example, the material of the nonlinear resistor layer 14 includes a perovskite composite oxide.

For example, the material of the nonlinear resistor layer 14 includes doped SrTiO₃, BaTiO₃, and LaMnO₃.

Alternatively, for example, the material of the nonlinear resistor layer 14 includes an organic polymer.

For example, the material of the nonlinear resistor layer 14 includes PEMA, PAM, PTPA, or PF₁₄-b-Pisoₙ.

In some other embodiments, the material of the nonlinear resistor layer 14 has a metal-insulator transition characteristic.

For example, the material of the nonlinear resistor layer 14 includes a solid electrolyte.

For example, the material of the nonlinear resistor layer 14 includes sulfide such as GeₓS_{y}, Ag₂S, and Cu₂S, iodide such as AgI and RbAg₄I₅, selenide such as GeₓSe_{y}, and telluride such as GeₓTe_{y}, SbₓTe_{y}, GeSbTe, and AgInSbTe.

In some embodiments, as shown in FIG. 13A to FIG. 14D, the ferroelectric capacitor C further includes at least one third electrode 15, the third electrode 15 is disposed between the first electrode 11 and the second electrode 12, and the third electrode 15 is disposed between the ferroelectric layer 13 and the nonlinear resistor layer 14.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A memory array, comprising:
a substrate, and
a plurality of memory cells disposed on the substrate, wherein each of the memory cells comprises a ferroelectric capacitor; and
the ferroelectric capacitor comprises:
a first electrode and a second electrode, and
a ferroelectric layer and at least one nonlinear resistor layer that are disposed between the first electrode and the second electrode, wherein
a material of the nonlinear resistor layer has a characteristic that a resistance nonlinearly decreases as an applied voltage increases.

2. The memory array according to claim 1, wherein the material of the nonlinear resistor layer is a conductive material having a resistive switching characteristic.

3. The memory array according to claim 1, wherein the material of the nonlinear resistor layer has a metal-insulator transition characteristic.

4. The memory array according to claim 1, wherein the material of the nonlinear resistor layer comprises a transition metal oxide, a lanthanum oxide, a perovskite composite oxide, a solid electrolyte, or an organic polymer.

5. The memory array according to claim 1, wherein the material of the nonlinear resistor layer comprises at least one of Ta₂O₅, Nb₂O₅, TiO₂, HfO₂, GeSbTe, or AgInSbTe.

6. The memory array according to any one of claims 1 to 4, wherein the ferroelectric capacitor further comprises at least one third electrode, and the third electrode is disposed between the first electrode and the second electrode; and
the third electrode is disposed between the ferroelectric layer and the nonlinear resistor layer.

7. The memory array according to any one of claims 1 to 6, wherein the first electrode and the second electrode are disposed in a direction perpendicular to the substrate.

8. The memory array according to any one of claims 1 to 6, wherein the first electrode and the second electrode are disposed in a direction parallel to the substrate.

9. The memory array according to any one of claims 1 to 8, wherein a material of the ferroelectric layer comprises a hafnium oxide-based material.

10. A memory array, comprising:
a substrate, and
a plurality of memory cells disposed on the substrate, wherein each of the memory cells comprises a ferroelectric capacitor; and
the ferroelectric capacitor comprises:
a first electrode and a second electrode, and
a ferroelectric layer and at least one nonlinear resistor layer that are disposed between the first electrode and the second electrode, wherein
a material of the nonlinear resistor layer is a conductive material having a resistive switching characteristic; or a material of the nonlinear resistor layer has a metal-insulator transition characteristic.

11. The memory array according to claim 10, wherein the material of the nonlinear resistor layer comprises a transition metal oxide, a lanthanum oxide, a perovskite composite oxide, a solid electrolyte, or an organic polymer.

12. The memory array according to claim 10, wherein the material of the nonlinear resistor layer comprises at least one of Ta₂O₅, Nb₂O₅, TiO₂, HfO₂, GeSbTe, or AgInSbTe.

13. The memory array according to any one of claims 10 to 12, wherein the ferroelectric capacitor further comprises at least one third electrode, and the third electrode is disposed between the first electrode and the second electrode; and
the third electrode is disposed between the ferroelectric layer and the nonlinear resistor layer.

14. The memory array according to any one of claims 10 to 13, wherein the first electrode and the second electrode are disposed in a direction perpendicular to the substrate.

15. The memory array according to any one of claims 10 to 14, wherein the first electrode and the second electrode are disposed in a direction parallel to the substrate.

16. The memory array according to any one of claims 10 to 15, wherein a material of the ferroelectric layer comprises a hafnium oxide-based material.

17. A memory, comprising a controller and the memory array according to any one of claims 1 to 16, wherein the controller is electrically connected to the memory array.

18. An electronic device, comprising a circuit board and the memory according to claim 17, wherein the circuit board is electrically connected to the memory.

19. A memory array preparation method, comprising:
forming a plurality of memory cells on a substrate, wherein each of the memory cells comprises a ferroelectric capacitor, wherein
the ferroelectric capacitor comprises a first electrode and a second electrode, and a ferroelectric layer and at least one nonlinear resistor layer that are disposed between the first electrode and the second electrode, and a material of the nonlinear resistor layer has a characteristic that a resistance nonlinearly decreases as an applied voltage increases.

20. The memory array preparation method according to claim 19, wherein the material of the nonlinear resistor layer is a conductive material having a resistive switching characteristic.

21. The memory array preparation method according to claim 19, wherein the material of the nonlinear resistor layer has a metal-insulator transition characteristic.

22. The memory array preparation method according to claim 19, wherein the material of the nonlinear resistor layer comprises a transition metal oxide, a lanthanum oxide, a perovskite composite oxide, a solid electrolyte, or an organic polymer.

23. The memory array preparation method according to claim 19, wherein the material of the nonlinear resistor layer comprises at least one of Ta₂O₅, Nb₂O₅, TiO₂, HfO₂, GeSbTe, or AgInSbTe.

24. The memory array preparation method according to any one of claims 19 to 23, wherein the ferroelectric capacitor further comprises at least one third electrode, the third electrode is disposed between the first electrode and the second electrode, and the third electrode is disposed between the ferroelectric layer and the nonlinear resistor layer.

25. A memory array preparation method, used to prepare the memory array according to any one of claims 10 to 16.
